(19) Europäisches Patentamt
European Patent Office
Office européen des brevets

(11) **EP 2 833 327 B1**

(12) **EUROPEAN PATENT SPECIFICATION**

(45) Date of publication and mention of the grant of the patent:
**03.10.2018 Bulletin 2018/40**

(51) Int Cl.:
*G06T 11/00* *(2006.01)*   *G01N 21/17* *(2006.01)*
*G01J 3/00* *(2006.01)*   *G06T 15/50* *(2011.01)*
*G06T 15/04* *(2011.01)*

(21) Application number: **14169088.3**

(22) Date of filing: **20.05.2014**

(54) **Method and system for digitally generating appearance data**

Verfahren und System zur digitalen Erzeugung von Erscheinungsdaten

Procédé et système pour générer numériquement des données d'apparence

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.07.2013 US 201313953285**

(43) Date of publication of application:
**04.02.2015 Bulletin 2015/06**

(73) Proprietor: X-Rite Switzerland GmbH
8105 Regensdorf (CH)

(72) Inventors:
• **Rump, Martin**
  **53809 Winterscheid (DE)**
• **Ellens, Marc S.**
  **Grand Rapids, NE 49505 (US)**
• **Kohlbrenner, Adrian**
  **8800 Thalwil (CH)**
• **Lamy, Francis**
  **8832 Wollerau (CH)**
• **Frick, Beat**
  **8107 Buchs (CH)**

(74) Representative: **Schwabe - Sandmair - Marx Patentanwälte Rechtsanwalt Partnerschaft mbB Joseph-Wild-Straße 20 81829 München (DE)**

(56) References cited:
**US-A1- 2011 148 898**

• **MARTIN RUMP ET AL: "Spectralization: Reconstructing spectra from sparse data", COMPUTER GRAPHICS FORUM, vol. 29, no. 4, 26 June 2010 (2010-06-26), pages 1347-1354, XP055135102, ISSN: 0167-7055, DOI: 10.1111/j.1467-8659.2010.01730.x**
• **ROLAND RUITERS ET AL: "BTF based Material Representations: Current Challenges", EG MAM 2013 - WORKSHOP ON MATERIAL APPEARANCE MODELING - ZARAGOZA, SPAIN - JUNE 19TH 2013, 19 June 2013 (2013-06-19), pages 1-4, XP055135376, DOI: 10.2312/MAM.MAM2013.017-020 ISBN: 978-3-90-567448-4**
• **ROLAND RUITERS ET AL: "Example-based Interpolation and Synthesis of Bidirectional Texture Functions", COMPUTER GRAPHICS FORUM, vol. 32, no. 2pt3, 6 May 2013 (2013-05-06), pages 361-370, XP055135237, ISSN: 0167-7055, DOI: 10.1111/cgf.12056**
• **KUN XU ET AL: "Edit Propagation on Bidirectional Texture Functions", COMPUTER GRAPHICS FORUM, vol. 28, no. 7, 1 October 2009 (2009-10-01), pages 1871-1877, XP055135093, ISSN: 0167-7055, DOI: 10.1111/j.1467-8659.2009.01565.x**
• **XIAOBO AN ET AL: "AppWarp: retargeting measured materials by appearance-space warping", ACM TRANSACTIONS ON GRAPHICS, vol. 30, no. 6, 1 December 2011 (2011-12-01), pages 147:1-147:9, XP055135041, ISSN: 0730-0301, DOI: 10.1145/2070781.2024181**

EP 2 833 327 B1

- R. PETER WEISTROFFER ET AL: "Efficient Basis Decomposition for Scattered Reflectance Data", PROCEEDING EGSR'07 - 18TH EUROGRAPHICS CONFERENCE ON RENDERING TECHNIQUES - GRENOBLE, FRANCE - JUNE 25-27, 2007, 25 June 2007 (2007-06-25), pages 207-218, XP055135383, DOI: 10.2312/EGWR/EGSR07/207-218
- FILIP J ET AL: "Bidirectional Texture Function Modeling: A State of the Art Survey", IEEE TRANSACTIONS ON PATTERN ANALYSIS AND MACHINE INTELLIGENCE, IEEE COMPUTER SOCIETY, USA, vol. 30, no. 11, 1 November 2009 (2009-11-01), pages 1921-1940, XP011292829, ISSN: 0162-8828
- LIBIN SUN ET AL: "Super-resolution from internet-scale scene matching", 2012 IEEE INTERNATIONAL CONFERENCE ON COMPUTATIONAL PHOTOGRAPHY (ICCP), 1 April 2012 (2012-04-01), pages 1-12, XP055135380, DOI: 10.1109/ICCPhot.2012.6215221 ISBN: 978-1-46-731661-3
- JAN KAUTZ ET AL: "Interactive editing and modeling of bidirectional texture functions", ACM TRANSACTIONS ON GRAPHICS, vol. 26, no. 3, 29 July 2007 (2007-07-29), pages 53:1-53:10, XP055135043, ISSN: 0730-0301, DOI: 10.1145/1276377.1276443

**Description**

The present invention relates to a method of digitally generating data indicative of a synthesized appearance according to the preamble of independent claim 1. The invention also relates to a system for generating such appearance data according to the preamble of independent claim 14.

More specifically the invention relates to the general field of visualization of real materials or surfaces on a monitor by using computer graphic techniques. In general, a digital representation of a real material or surface is rendered, mapped onto a target object of arbitrary shape, and the simulated appearance of the target object is then visualized under user selected illumination conditions and viewing directions.

From the start, it should be understood that the field of this invention is not image creation or manipulation, which typically includes only 2- and 3- dimensions and does not require that the result resemble reality, much less be renderable in reality. The field here is visualization of simulated materials that are renderable in reality - they are physically plausible materials.

Getting an accurate visualization of a simulated appearance is, for most materials and surfaces occurring in the real world, an extremely challenging technological problem. Consequently, much effort has been expended on finding approximations that are both of aesthetically pleasing appearance and quickly computed, albeit without concern that the resultant appearance is representative of a material that is physically plausible, such as required by a product designer.

Further, in creative applications like product design, large databases of materials are required. Various functions have been developed, such as the Bidirectional Texture Function (BTF), which is a material representation fitting a large number of complex materials of many different types. However, to measure a sufficiently representative BTF for a given real material requires relatively complex measuring equipment and the measurements are very time consuming. A representative surface area of the material must be measured pixel by pixel for a large number of illumination directions and viewing directions, typically by using a number of digital color cameras and a complex illumination system with hundreds of spot-type lamps distributed over the hemisphere above the material being measured.

With the BTF measured, the visualization itself, i.e. the graphical representation of the material on the monitor under any desired illumination condition and any desired viewing direction and applied or mapped to any object of any shape, is realized by digital rendering techniques which use the BTF database as input data. Suitable rendering techniques and software are well known in the computer graphics art and are not subject of the present invention. Such rendering techniques or software can retrieve color reflectance values from the BTF database for each given pixel of the real material for each given illumination direction and for each given viewing direction. Intermediate values can be calculated by interpolation from the actual values stored in the BTF database.

Unfortunately, the creation of such databases usually containing thousands of materials requires substantial technical effort both in terms of measurement time and device sophistication and is therefore often not practicable and often prohibitively expensive.

As an alternative to producing databases for a large number of individual materials a set of basis materials with corresponding BTFs might be provided from which the designer can chose a sample and then modify or edit the BTF on-the-fly to meet his requirements. Here, an intuitive and fast editing approach is necessary to maintain efficiency in the creative process. Moreover, the goal of the editing process is to generate physically plausible results that represent simulated materials that may be actually manufactured.

The problem of editing measured reflectance has been tackled in previous work as well. All literature references are specified in more detail at the end of this document. One common approach is to fit analytical reflectance models to the data ([McAllister2002], [Daubert2001]) and to perform a modification of model parameters afterwards. For efficient parameter changes additional methods might be used which simplify propagation of parameters across the material surface [An2008]. While using reflectance models guarantees physical plausibility to a certain degree, manually finding new parameters to match a desired target appearance is a tedious task. Moreover, this approach is limited to materials which can be faithfully described by simple reflectance models. Most complex materials, especially those exhibiting special features like glittering or significant and large surface structures, cannot be reproduced by such an approach with high accuracy.

Other methods do not rely on analytical models but modify reflectance data in a more direct way. [Lawrence 2006] used inverse shade trees and an optimization scheme coined ACLS to decompose the spatially varying material properties of planar samples from dense hemispherical samplings in a collection of 1D curves and 2D textures. This approach factorized the material into multiple, low-dimensional parts, which could be edited separately, causing certain reflectance changes on the whole material when reconstructing from the factorized representation. While this approach allows for a high-accuracy representation of the source material, editing of the single parts still remains a manual process and a desired target appearance is therefore difficult to achieve. Moreover, the method is only applicable for flat materials.

In [Kautz2007] a first set of editing operators for generic BTF data was proposed. While those operators can deal with arbitrarily complex materials, their heuristic nature does not allow guaranteeing physical plausibility of the final result. Additionally, a given target material is very difficult to match as the operator parameters have to be specified manually.

A combination of the edit propagation algorithm [An2008] and the editing operators defined in [Kautz2007] was made by Xu et al. [Xu2009]. While this simplifies the usage of the edit operators, it does not circumvent the basic problems of physical implausibility and manual work.

Using measured reflectance on both the source and target side of the editing process was proposed in [An2011]. This algorithm can transfer reflectance data from one material to match the spatial reflectance distribution of a second material allowing for very intuitive editing with minimal manual effort. While the method allows to enrich sparsely captured representations (even single images) with highly detailed reflectance data, the other way around is not possible as the edited material is always represented by reflectance samples from the target material.

In the patent application published with the number US 2011/0148898, a method and an apparatus for the processing and rendering of layers of a multi-layered material, comprising interpolation of material information, is disclosed.

There is a need to easily and quickly develop a synthesized appearance of a simulated material that not only "looks good," but is physically plausible to enable product designers to evaluate a wide range of simulated materials, knowing that any material selected by the designer from the range of materials is physically plausible for making real world products.

Accordingly, an object of the present invention is to provide an improved method of digitally generating, via the use of a computer, data indicative of a synthesized appearance of a simulated material having physically plausible appearance attributes. A more specific object of the present invention is to provide an improved method for the visualization of real materials that doesn't require individually measured appearance databases for all individual materials to be visualized and thus considerably reduces the amount of pre-captured data.

Another object of the present invention is to provide an improved visualization method which is based on an actually measured BTF database for a real material and which derives from said measured BTF database edited or modified BTF databases for other real materials so as to as closely as possible match the appearance properties of these other materials.

Yet another object of the present invention is to provide an improved visualization method in which an actually measured densely populated BTF database for a real reference material is modified by sparsely captured reflectance data of a real source material to produce a modified BTF database resembling as closely as possible the appearance properties of said real source material.

Yet a further object of the present invention is to provide an improved visualization method which is intuitive and yields physically plausible results by picking simple attributes like color and coarse reflectance properties from a real source material and which transfers these attributes to the measured densely populated BTF of said reference material. Thereby, such simple attributes should be measurable using small, cost-efficient and fast measurement devices.

These objects are met by the method according to the invention which is defined in its most general terms by the features of independent claim 1. Advantageous refinements and embodiments of the inventive method are subjects of the dependent claims.

In its most general terms the claimed inventive method comprises the steps of:

> (a) accessing a first set of data indicative of the values of measured appearance attributes of the reference material, with the measured appearance attributes being measured at a plurality of locations on the reference material and for a plurality of illumination directions or a plurality of viewing directions relative to each of the locations;
> (b) accessing a second set of data indicative of a value of at least one measured appearance attribute of the source material, wherein the appearance attribute of the source material includes at least one, but not all, of the appearance attributes being measured on the reference material; and
> (c) determining a third set of data indicative of the synthesized appearance of the simulated material based at least in part on data from the second set of data associated with the physically tangible source material and at least in part on data from the first set of data of measured attributes of the physically tangible reference material different from that of the second set of data.

Preferably, the method further comprises measuring appearance attributes of the physically tangible reference material at a plurality of locations on the reference material by illuminating each of the locations on the reference material with EM radiation in the range of near IR, UV or humanly detectable frequency spectra from a plurality of illumination directions and measuring the EM radiation reflected from or transmitted through the reference material, preferably from a plurality of viewing directions, and determining values of the appearance attributes of the reference material based on the reflected or transmitted EM radiation to form the first set of data.

Step (c) of the claimed inventive method comprises:

> (i) determining a third set of data indicative of the synthesized appearance of the simulated material based at least in part on the values of the measured appearance attributes of the source material and the values of the measured appearance attributes of the reference material,

(ii) determining an error value consisting of

(iia) the difference between a parameter of a measured appearance attribute of the source material and the same parameter of the corresponding appearance attribute in the third set of data,

(iib) a physical plausibility value based on the difference between a parameter of a measured appearance attribute of the reference material and the same parameter of the corresponding measured appearance attribute in the third set of data,

(iii) if the error value is greater than a predetermined threshold, then revising the determining of the third set of data indicative of the synthesized appearance of the simulated material, and

(iv) repeating steps (i) through (iii) until the error value is less than the predetermined threshold or the change of the error value is less than a second, predetermined threshold.

The first set of data constitutes a Bidirectional Texture Function (BTF), a Bi-Directional Scattering-Surface Reflectance Distribution Function (BSSRDF), a Spatially Varying Bi-Directional Transmission Distribution Function (SVBTDF), or a Spatially Varying Bi-Directional Reflectance Distribution Function (SVBRDF).

The second set of data is indicative of values of a plurality of measured appearance attributes of the source material, and wherein the appearance attributes of the source material include some, but not all, of the appearance attributes being measured on the reference material.

The appearance attributes are selected from but not limited to the group consisting of lightness, saturation, hue, gloss, specularity, distinctness of image, haze, subsurface scattering, translucency, turbidity, texture, surface height variation and normal maps.

The appearance attribute is for instance mesurable via EM radiation in the near IR, UV or humanly detectable frequency spectra reflected from or transmitted through the reference material or the source material of the simulated material.

In some techniques not covered by the appended claims, the method further comprises processing the third set of data to form an image representative of the synthesized appearance of the simulated material. The image may be three dimensional.

In some techniques not covered by the appended claims, the method further comprises processing the third set of data to print a physically tangible object having the synthesized appearance of the simulated material.

In some techniques not covered by the appended claims, the method further comprises processing the third set of data to form a haptic display representative of the synthesized appearance of the simulated material.

In some techniques not covered by the appended claims, the method further comprises accessing a fourth set of data indicative of standardized values of appearance attributes representative of a family of generally similar physically tangible materials of which the reference material or the source material is a member, and determining the third set of data based at least in part from data from the fourth set of data.

Preferably, the number of appearance attributes represented in the second set of data is for example less than 1% of the number of appearance attributes represented in the first set of data.

In some techniques not covered by the appended claims, the method further comprises providing a densely populated original BTF of a reference material, providing sparse reflectance values of a source material, and building a modified BTF by transferring said sparse reflectance values into said original BTF, whereby said modified BTF represents a simulated material combining appearance properties of both the reference material and the source material.

In some techniques not covered by the appended claims, the method further comprises selecting from the original BTF pixels for which the original BTF is to be modified and wherein selecting pixels comprises assigning weights to the pixels of the original BTF on the basis of similarity between the reflectance values of the pixels and the sparse reflectance values.

In some techniques not covered by the appended claims, the method further comprises building a first error term measuring a color difference between the simulated material represented by the selected pixels of the modified BTF and the sparse reflectance values of the source material and building a second error term measuring an appearance difference between the reference material as represented by the original BTF and the simulated material represented by the modified BTF.

In some techniques not covered by the appended claims, building the first error term comprises a simulated reflectance measurement of the simulated material represented by the modified BTF.

In some techniques not covered by the appended claims, building the modified BTF comprises iteratively minimizing an error function comprising the first and second error terms whereby each iteration step generates an intermediate BTF initializing the next following iteration step and whereby iteration is terminated when the error function becomes smaller than a threshold value or when convergence of the iteration procedure is detected.

More specifically, the error function is for example represented by formula 2 hereinafter.

In some techniques not covered by the appended claims, building the modified BTF comprises applying BTF editing operators to the original BTF or the intermediate BTF. The BTF editing operators include a hue change operator, a saturation change operator and a specularity change operator and each of these hue, saturation and specularity change operators has a parameter.

The method according to the present invention is particularly suitable for the visualization of sets of structurally identical or at least similar real materials differing only with respect to color and/or design. An illustrative but in no way limiting example of such a set of real materials is a set of textiles which are all made of the same fabric but have differing designs in terms of color. Other materials for the visualization of which the method of the present invention is particularly suitable and advantageous, are the classes of near-homogeneous, near-flat and automotive paint materials.

The present invention also provides a data set of values of appearance attributes for a synthesized appearance of a simulated material having physically plausible appearance attributes generated by the method of the present invention.

The present invention also provides an image generated from a data set of values of appearance attributes for a synthesized appearance of a simulated material having physically plausible appearance attributes generated by the method of the present invention.

The present invention also provides a system for digitally generating data indicative of a synthesized appearance of a simulated material having physically plausible appearance attributes, with the synthesized appearance being based on a physically tangible reference material and at least one value of a selected appearance attribute of a physically tangible source material different from the reference material. In accordance with the independent claim 14 the system comprises (a) a memory for storing a first set of data indicative of the values of measured appearance attributes of the reference material, with the measured appearance attributes being measured at a plurality of locations on the reference material and for a plurality of illumination directions or a plurality of viewing directions relative to each of the locations; (b) an instrument for measuring at least one appearance attribute of the source material and generating a second set of data indicative of a value of the measured appearance attribute, wherein the appearance attribute of the source material includes at least one, but not all, of the appearance attributes being measured on the reference material; and (c) a computer configured to receive the first and second sets of data and configured to determine a third set of data indicative of the synthesized appearance of the simulated material based at least in part on data from the second set of data associated with the physically tangible source material and at least in part on data from the first set of data of measured attributes of the physically tangible reference material different from that of the second set of data.

In some embodiments the system further comprises a processor configured to receive data from the third set of data and configured to form an image representative of the synthesized appearance of the simulated material based at least in part on the data from the third set of data.

In some techniques not covered by the appended claims, the system further comprises a processor configured to receive data from the third set of data and configured to produce an object having the synthesized appearance of the simulated material based at least in part on the data from the third set of data.

In some techniques not covered by the appended claims, at least a portion of the memory for storing the first set of data is carried on the computer.

In some techniques not covered by the appended claims, the computer and the instrument are combined in a single integral device.

In some techniques not covered by the appended claims, the computer and the processor are combined in a single integral device.

In some techniques not covered by the appended claims, the system further comprises transmitting means for transmitting data from the first and second sets of data via media selected from the group consisting of a hardware connection, a wireless connection or a portable memory device.

The instrument for example comprises at least one source of EM radiation in the range of near IR, UV or humanly detectable frequency spectra.

In some techniques not covered by the appended claims, the instrument source emits the full spectra of EM radiation in the range of near IR, UV and humanly detectable frequency spectra. In other techniques not covered by the appended claims, the instrument source emits a selected spectrum of EM radiation from the range of near IR, UV and humanly detectable frequency spectra.

In some techniques not covered by the appended claims, the instrument further comprises at least one detector for measuring EM radiation reflected from or transmitted through the source material when illuminated by the source of EM radiation, and determining values of the appearance attributes of the source material.

In some techniques not covered by the appended claims, the system comprises a second instrument for measuring appearance attributes of the physically tangible reference material at a plurality of locations on the reference material by illuminating each of the locations on the reference material with EM radiation in the range of near IR, UV or humanly detectable frequency spectra from a plurality of illumination directions and measuring the EM radiation reflected from or transmitted through the reference material from a plurality of viewing directions, and determining values of the appearance attributes of the reference material based on the reflected or transmitted EM radiation for data of the first set of data.

In the following preferred embodiments of the method and the system according to the invention will be described in full detail with reference to the accompanying drawings in which

Fig. 1 is a flow diagram of the general outline of one embodiment of the inventive method,

Fig. 2 is a flow diagram of one embodiment of a method for selecting pixels to be edited,

Fig. 3 is a flow diagram of the generic iteration procedure for minimizing an error function used in the method of the invention,

Fig. 4 is a flow diagram of a procedure for determining parameters of editing operators used in the iteration procedure shown in Fig. 3,

Fig. 5 is a flow diagram of a sub procedure of the procedure shown in Fig. 4, and

Fig. 6 is a schematic outline of an embodiment of the inventive system.

The following nomenclature and abbreviations are used throughout the present patent specification and the accompanying drawings:

BTF denotes a bidirectional texture function or database. The BTF is a six dimensional function containing a color reflectance or transmittance value (e.g. but not necessarily RGB) for every point (pixel) on a surface area of the material (2 spatial dimensions, i.e x,y-coordinates) as well as for a large number of viewing and illumination directions (2*2 spatial direction dimensions, i.e. 2 elevation and 2 azimuth angles). Due to its discrete nature the BTF is a collection of data or database rather than a continuous function in the strict mathematical sense. In the following the terms BTF, BTF function and BTF database will be used synonymously.

B denotes a (densely populated) BTF measured for a reference material also referred to as target material. For each pixel of the measured area of the reference material and for a large number of illumination and viewing directions B holds a set of reflectance or transmittance values which can be e.g. RGB color values or spectral values. In the following sets of reflectance values will be referred to shortly as reflectance values or color values.

D denotes the totality of sparsely captured reflectance or transmittance values of one measuring point or spot of a source material (other than the reference or target material). The sparsely captured reflectance or transmittance values D actually consist of a single set or a plurality of sets of e.g. RGB values or other color values or spectral values. If the source material is measured under one specific illumination condition and in one specific viewing direction only a single set of reflectance or transmittance values results. If the source material is measured under several illumination directions and/or viewing directions a plurality s of sets $D_s$ results according to the number of combinations of illumination and viewing directions. A typical color measuring device suitable for capturing sparse reflectance values is the device MA98 of X-Rite Inc., Grand Rapids, MI, USA. This device features multi-angle illumination and multi-angle measuring light pick-up and produces 19 sets of reflectance values for each measuring spot. In the following sets of reflectance or transmittance values will be referred to simply as reflectance values or color values. A measuring device for capturing said sparse reflectance or transmittance values is referred to hereinafter also as simple scanner. For the sake of completeness it is to be mentioned that the reflectance or transmittance values D may also be taken, in practical use, from a database or from a suitable color chart or the like.

B' denotes a (densely populated) BTF database derived from B by modifying the original BTF B with sparse reflectance or transmittance values D. Modifying a BTF is also referred to as editing a BTF. The modified BTF B' represents a simulated material that combines appearance properties of both the reference material and the source material.

As reflectance values D will be transferred to B the reflectance values D have to be of the same type as those of B, i.e. e.g. RGB color values or spectral values or any other suitable color values. Otherwise either the reflectance values of B or preferably those of D have to be converted correspondingly.

Furthermore the following definitions are used herein:

"Synthesized appearance" means an appearance which is generated from the appearance attributes of both the source and reference materials. It needs not have identical size or format to either reference or source materials. The synthesized appearance will look more like the reference material than the source material. Suitable appearance attributes include, for example, lightness, saturation, texture, color, hue, gloss, specularity, distinctness of image, haze, subsurface scattering, turbidity, translucency, surface height variation and normal maps, etc.

"Reference material" means a material which has been extensively measured to densely populate a data set of a plurality of appearance attributes.

"Source material" means a material which has been measured to sparsely populate a data set of one or more appearance attributes. In some embodiments, the source and reference materials are related (e.g. both may have one or more of the same appearance attributes such as gloss, surface, color, etc.). In other instances, they may differ (i.e. they may have no similar appearance attributes).

"Physically plausible" means that the simulated material is typically capable of being created in the physical, real world. The term "physically plausible" is used in contrast to that of "physically feasible." A "physically feasible" appearance is one that one can imagine constructing physically, but the real-world construction of such materials may not be possible. The present invention enables creation of physically plausible simulated materials because the first and second data sets are physically measured from tangible source and reference materials.

As stated above, all literature references referred to in the present description are specified in more detail in the references list at the end of the description.

For the sake of simplicity only reflectance values are addressed in the following description. It is clear to those skilled in the art that all data processing steps hold in an analogous manner for transmittance values as well.

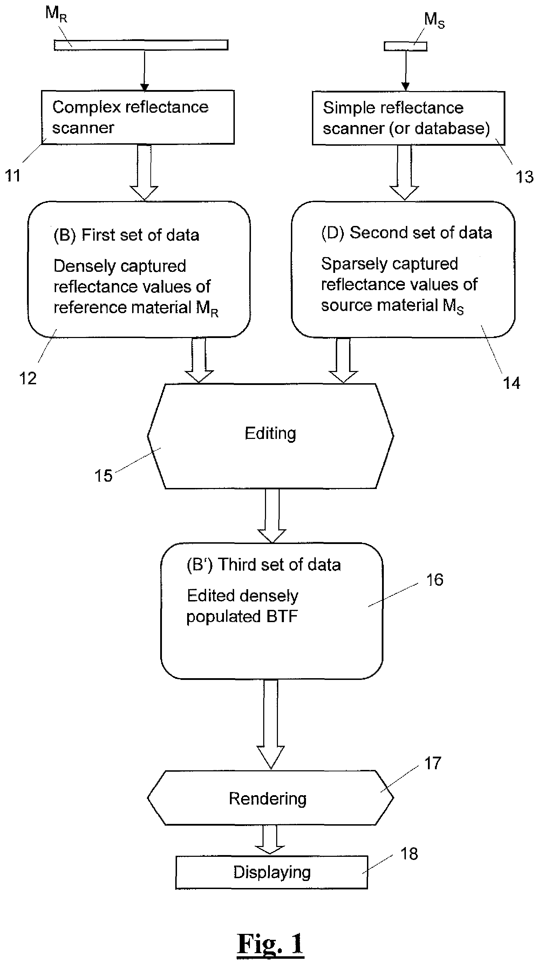

Fig. 1 shows an overview of a representative embodiment of the method according to the invention.

The first, preparatory method steps consist of data acquisition for both the source and reference materials.

A sufficiently large surface area of a reference material $M_R$ is measured using a complex reflectance scanner (box 11) to provide a set of reflectance values for each pixel of the scanned surface area under a large number of illumination directions (at least 5, more preferably at least 10) and a large number of viewing directions (at least 5, more preferably at least 10) as outlined above. The result is a first set of data indicative of the values of measured appearance attributes of the $M_R$. This first set of data is also referred to herein as the densely populated original BTF database B for the $M_R$ (box 12).

In other embodiments, the first set of data constitutes a Bi-Directional Scattering-Surface Reflectance Distribution Function (BSSRDF), a Spatially Varying Bi-Directional Transmission Distribution Function (SVBTDF), or a Spatially Varying Bi-Directional Reflectance Distribution Function (SVBRDF). These various types of functions including the BTF are generally referred to, hereinafter, as appearance function. For the sake of simplicity however, the inventive method is explained hereinafter with reference to the first and third sets of data (or said appearance function) constituting a Bidirectional Texture Function BTF.

Furthermore, a measuring spot of a source material $M_S$ is measured using a simple reflectance scanner or color measuring device (box 13) to provide sparse reflectance values D (box 14). The result is a second set of data indicative of a value of at least one measured appearance attribute of the $M_S$. The appearance attribute of the $M_S$ includes at least one, but not all, of the appearance attributes measured on the $M_R$. The second set of data is also referred to herein as the "sparsely populated" data set. "Sparse" means less than at least 50% the amount in the densely populated BTF database B for the $M_R$. In some embodiments, the number of appearance attributes in the data collected from the $M_S$ may be less than 1% of the number of appearance attributes represented in the BTF of the $M_R$.

The data acquisition steps are known per se and can be implemented by any suitable measurement equipment (including, for example, a spectrophotometer). The materials can be illuminated with electromagnetic (EM) radiation in the range of near IR, UV or humanly detectable frequency spectra.

The BTF data B for the $M_R$ can be acquired at the same time or at a different time than the data for the $M_S$. The BTF data B for the $M_R$ can be stored on the same computer or on a different computer used to store the data from the $M_S$.

In the next and most important step (box 15) of the inventive method a third set of data indicative of the synthesized appearance of the simulated material is determined based at least in part on data from the second set of data associated with the $M_S$ and at least in part on data from the first set of data associated with the $M_R$. More specifically, the original BTF B of the $M_R$ is edited (modified) by transferring the sparse reflectance values D of the $M_S$ into the BTF B (box 15). In this editing step, a modified BTF B' is produced which is populated as densely as B but has reflectance values that make B' resemble the source material $M_S$, i.e. the reflectance values of B' are as similar as possible to reflectance values which would have been obtained if the BTF of the source material had been actually measured. The method of the present invention results in a third set of data indicative of physically plausible appearance attributes.

In some embodiments, the third set of data is determined based at least in part from data from the first and second data as well as data from a fourth set of data indicative of standardized values of appearance attributes representative of a family of generally similar physically tangible materials of which the reference material or the source material is a member.

The third set of data may optionally be processed to form an image representative of the synthesized appearance of the simulated material. In some embodiments, the image may be 3-dimensional. Figure 1 shows the third set of data, i.e. the edited BTF B' (box 16) can be fed as input data to a conventional rendering engine (box 17) and visualized on a display (box 18). Rendering and displaying a BTF are known in the art and are not subjects of the present invention per se.

The determination of the third set of data can involve a correction to increase its physical plausibility. In some embodiments, an error value is used to correct the data. In some embodiments, the error value consists of (a) the difference between a parameter of a measured appearance attribute of the source material and the same parameter of the corresponding appearance attribute in the third set of data and (b) a physical plausibility value based on the difference between at least one, preferably at least two, parameter(s) of between at least one, preferably at least two, measured appearance attribute(s) of the reference material and the same parameter(s) of the corresponding measured appearance attribute(s) in the third set of data. In some embodiments, if the error value is greater than a predetermined threshold, then the third set of data is revised until the error value is less than the predetermined threshold value.

The core feature of the method of the present invention consists in the step of determination of the third set of data (box 15). The following description, therefore, focuses mainly on this step.

For an easier understanding, a simple practical example will make clear the goal of the invention. Assume a designer wishes to know what different designs of upholstery would look like in a real car. He has a relatively large variety of individual seat cover materials that are all made of the same textile fabric and, therefore, have the same or at least a very similar surface structure. The only difference between the individual materials may consist in their color patterns. All materials may have colored spots. One particular material may have white spots, another one may have red spots, a third one may have green spots, and so on. To visualize all these individual materials on a computer monitor according to the present invention only one of the materials needs to be densely scanned to produce a full reference BTF. The BTFs for the remaining materials can then be generated on the fly from the reference BTF by editing or modifying whereby the editing procedure requires information on which pixels of the material to be visualized are different and in what aspect (e.g. color) they are different from the reference material. Accordingly, the first, preparatory step of the editing procedure is to select those pixels of the source material $M_S$ that are different from the respective pixels of the reference material $M_R$, or in other words to select the pixels of which the corresponding reflectance values are to be edited (shortly pixels to be edited).

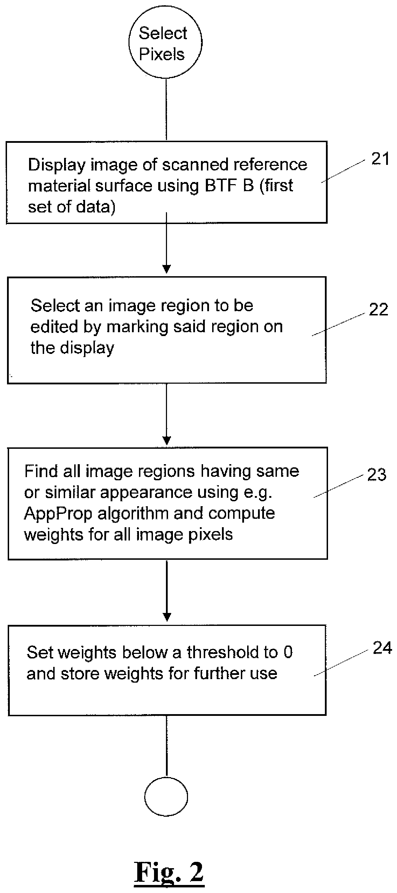

Theoretically, the pixels to be edited could be specified manually via their spatial coordinates. This, however, would be rather tedious, particularly if a large number of pixels are involved. Therefore, a software-assisted procedure is used as outlined in Fig. 2.

Selecting a pixel means that it is assigned a non-zero weight so that it is fully or at least partly considered in subsequent calculations. Pixels with zero weight are not considered in subsequent calculations. The weights build a selection mask.

In a first step of the pixel selection procedure one image of the scanned surface of the reference material $M_R$ is displayed on a computer monitor using a subset of data of the BTF B (box 21). The user then has to mark in the image displayed a surface region he wants to edit later, e.g. a spot of a certain color (box 22). Marking can be performed by any suitably designed interactive routine known in the art.

Afterwards all similar surface regions are located either manually or by applying an algorithm such as, e.g., the AppProp algorithm described in [An 2008] and weights $w_x$ are determined and assigned to all pixels x of the scanned surface (box 23). The AppProp algorithm works on the basis of self-similarities and calculates the weights so that all similar regions on the whole material surface get a high weight equal to or near one and all other regions receive a low weight equal to or near zero.

The AppProp algorithm is based on the minimization of an error function to propagate weights for selected pixels along similar appearance, leading to an intuitive continuation of selection. In some embodiments of the present invention, all weights of a set of pixels below a certain threshold are set to zero, i.e. only pixels with non-zero weights pertain to the set of pixels to be edited and will be considered for further calculations.

The AppProp algorithm is modified minimizes the following error function:

$$E(w) = \sum_{x \in S} |w_x - 1| + \sum_{x} \sum_{n \in N_x} |w_x - w_n| + \sum_{x \notin S} |w_x| \qquad \text{(formula 1)}$$

where S is the set of pixels (region) selected by the user. The first term of this error function aims to keep the weights for selected pixels equal to 1, while the last term aims to zero all other weights. The middle term regularizes the weights by keeping each weight $w_x$ similar to the weights $w_n$ in a certain appearance neighborhood $N_x$ of x. This leads to a propagation of weights along similar appearance and leads to an intuitive continuation of selection. The set of selected pixels $P$ for the editing process itself is then limited by setting all $w_x$ below a certain threshold to zero, i.e. only pixels with non-zero weights $w_x$ pertain to the set of pixels to be edited and will be considered for further calculations (box 24).

This optional modifying procedure of the inventive method needs to know what the selected pixels to be edited should finally look like. This information is provided by the sparse reflection values D captured from the corresponding measuring spot of the source material $M_S$.

The modifying procedure basically comprises an optimization procedure which minimizes an error function E(B'). This error function measures two different kinds of errors: A first part measures the (appearance) difference between a simulated material represented by the modified BTF B' and the sparse reflectance values D of the source material, and second part measures the (appearance) difference between the reference material as represented by its BTF B and the simulated material represented by the modified BTF B'. The first error part makes the edited (simulated) material look like the source material and the second error part ensures minimal deviation of the edited (simulated) material from the known reference material, therefore ensuring physical plausibility.

To measure a sensible difference between $B'$ and $D,$ the first part of the error function includes a simulated measurement of the (simulated) material represented by $B'$ with the simple reflectance scanner used for measuring the sparse reflectance values D. For this purpose a rendering of $B'$ under the illumination and viewing conditions of the simple reflectance scanner is computed with standard methods from the area of computer graphics and the difference of the result to $D$ is computed. The simulated measurement requires knowledge of the internal lighting and the detectors inside of the simple reflectance scanner, which are either known by design of the instrument or can be measured.

The error function E(B') can therefore be stated as follows:

$$\mathrm{E}(\mathrm{B}') = \sum_{s=1}^{N} \left\| S_s - D_s \right\| + \beta_u \beta_a \left\| B' - B \right\|_{BTF}$$

$$wherein \qquad\qquad\qquad (\text{formula } 2)$$

$$S_s = \frac{1}{\sum_{x \in P} w_x} \sum_{x \in P} w_x \int_{\omega_i \in \Omega} B'(x, \omega_i, \omega_o^s) L_i^s(\omega_i) d\omega_i$$

Here, the source reflectance values D are given as N sample values $D_s$ captured with viewing direction $\omega_o^s$ and under incident hemispherical radiance field $L_i^s$ defined on the upper hemisphere $\Omega$. The set of edited pixels x is called $P$ with all pixels x also having assigned a weight $w_x$ between 0 and 1. $w_x$ can therefore be interpreted as a smooth editing mask on the material. The mask is determined as outlined above in the context of Fig. 2.

The central integral over all illumination directions $\omega_i$ in $S_s$ originates from the rendering equation as described in [Kajiya1986] and can be interpreted as taking a virtual measurement of pixel x of (virtual) material $B'$ with the simple reflectance scanner described by viewing angles $\omega_o^s$ and in-scanner illumination conditions $L_i^s$. These parameters $\omega_o^s$ and $L_i^s$ are either known by design of the instrument (simple reflectance scanner) or they can be measured. $S_s$ is the weighted average of the virtual measurement over the edited pixels P.

The terms $\|S_s - D_s\|$ are conventional color distance measures such as e.g. CIE $\Delta E^*$. Simpler measures such as L1 errors may be used as well.

The term $\|B' - B\|_{BTF}$ is a standard measure on the similarity of two BTFs. Here, measures ranging from simple point-wise squared distances up to complicated perceptual error measures like the BTF-CIELab as described in [Guthe2009] can be used.

The first term of the error function minimizes the difference between the edited BTF and the measured reflectance data, making the respective part of the target material look like the source material. The second term ensures similarity of the edited BTF with the original one ensuring physical plausibility of the result.

The weighting factors $\beta_a$ and $\beta_u$ have two different functions:

$\beta_a$ compensates for scale differences between the two different parts of error measures and is set according to the error measures actually used. For CIE $\Delta E^*$ on the one hand and BTF-CIELab on the other hand the error measures have the same scale so that $\beta_a$ would typically equal 1.

$\beta_u$ controls the method, as higher values for it will lead to less deviation from the target material and vice versa. This weighting factor can be chosen by the user in order to put more emphasis to the first or to the second error part, respectively.

As already mentioned above the modifying or editing procedure is implemented by optimizing, i.e. minimizing the above error function E(B') with B' as represented by its reflection values as variables. In other words, B' or its reflection values B' have to be modified in such a way that the error function E(B') becomes minimal. This task is achieved by iteration starting with the reflection values of B as zero-order approach (B' = B).

Many materials are too complex to be faithfully represented by simple models so that no assumption about the internal representation of their BTFs can be made. In order to minimize the error function, according to a further important aspect of the present invention, a heuristic approach based on BTF editing operators defined in [Kautz2007] is used for modifying the BTF and thereby minimizing the error function E(B').

The BTF editing operators of [Kautz2007] basically comprise four operators which, when applied to a BTF, allow for modification of the BTF with respect to gray scaling, color change (both saturation and hue) and gloss or specularity change. Each operator comprises one parameter only. By setting these parameters to higher or lower values and applying the operators to a BTF a desired scaling or color or specularity (gloss) change can be performed, respectively. Using these operators the problem of minimizing the error function E(B') is considerably reduced because only a few parameters have to be estimated so as to minimize the error function.

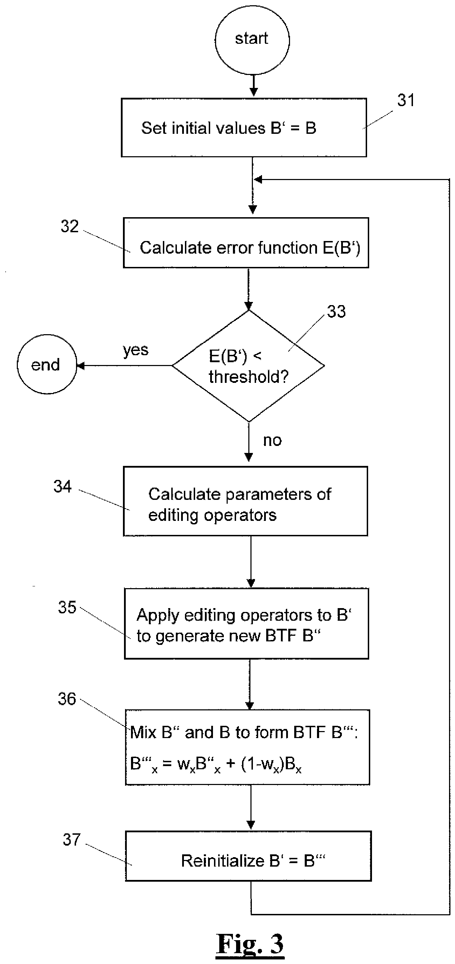

The iterative minimizing procedure for minimizing the error function E(B') is shown schematically in the flow diagram of Fig. 3.

After defining the pixels x to be edited and computing and assigning weights $w_x$ to them as outlined in Fig. 2, an iterative algorithm is used to transfer the sparse reflectance data D into B'. At the beginning, as mentioned already, B' is initialized with the values of B (box 31). Then the error function E(B') is calculated (box 32) and its value is compared with a preset threshold value (box 33). The values Ss resulting from the simulated measurement of B' are stored for later use. If the error function value is below the threshold value or convergence has been detected the iteration procedure is terminated. Otherwise, parameters for the Kautz et al editing operators are calculated (box 34) and with these parameters the Kautz et al editing operators are applied to B' to produce a new BTF B" (box 35). For the selected pixels x the values of this new BTF B" are than mixed with the values of the original BTF B according to $B'''_x = w_x B''_x + (1-w_x)B_x$ wherein $w_x$ are the weights assigned to the selected pixels x and $B'''_x$ are the values of an intermediate modified B''' for the pixels x (box 36). Then B' is reinitialized by setting B' = B''' (box 37). Afterwards the iteration procedure is then started over at box 32 so as to iteratively modify B'.

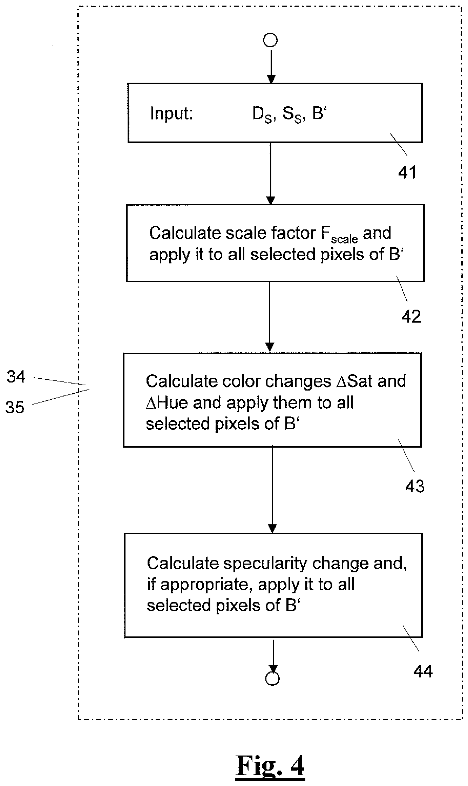

In the following the (sub) procedure of estimating parameters for the Kautz et al editing operators and of applying these operators to the current B' (boxes 34 and 35 of Fig. 3) will be explained in the context of the flow diagram of Fig. 4.

The (sub) procedure uses $D_S$ and the current states of B' and $S_S$ as input data (box 41).

At first a scaling is applied to B' by multiplying all reflectance values of B' with a scale factor $F_{scale}$ (box 42). Since light transport is linear, scaling all reflectance values of B' with the same scale factor is a physically plausible operation as long as the law of energy conservation is obeyed, i.e. $F_{scale}$ cannot be too high. The scale factor $F_{scale}$ is determined by comparison of the real measurements $D_s$ of the source material and the virtual measurements $S_s$ of the edited (simulated) material according to:

$$F_{scale} = \frac{1}{N}\sum_{s=1}^{N}\frac{G(D_s)}{G(S_s)} \qquad \text{(formula 3)}$$

where $G(D_S)$ and $G(S_S)$ each is a function computing a gray value from a color value. E.g. in the case of RGB color values, this would be the sum R+G+B. Then this scale factor $F_{scale}$ is applied to the reflectance values of all selected pixels of B', i.e. to all pixels $x \in P$ of B'.

Next a color change in both saturation and hue is calculated and a corresponding color transformation is applied to B' using the Kautz et al color change operator (box 43). The color change operator operates in HSV color space (hue, saturation, value) and can change the hue and saturation of BTF pixels in a physically plausible way. The color changes ΔHue and ΔSat in hue and saturation are calculated by comparison of the real measurements $D_s$ of the source material and the virtual measurements $S_s$ of the edited material according to:

$$\Delta Hue = \frac{1}{N}\sum_{s=1}^{N}\left[Hue(D_s) - Hue(S_s)\right]$$

$$\Delta Sat = \frac{1}{N}\sum_{s=1}^{N}\left[Sat(D_s) - Sat(S_s)\right] \qquad \text{(formula 4)}$$

Hue and saturation values used in this formula are calculated from the reflectance values $D_S$ and $S_S$ by known standard conversion formulas.

ΔHue and ΔSat are additive changes to be applied to the hue and saturation of B'. The color change operator from [Kautz2007] is run on all selected pixels $x \in P$ of B' using ΔHue and ΔSat as parameters.

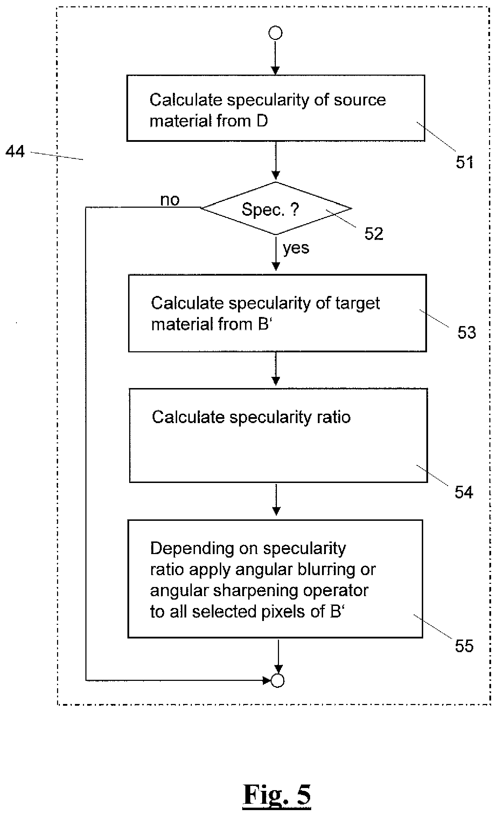

Afterwards, if the simple reflectance scanner and thus the values D support for estimating the materials specularity, a specularity change is calculated and, if applicable, applied to B' (box 44). For this purpose the angular sharpening or angular blurring operators from [Kautz2007] are used. The specularity change sub procedure of box 44 is shown in more detail in Fig. 5.

First the specularity of the source material is determined from the sparse reflectance values D (box 51). For this, an analytical BRDF (Bidirectional Reflectance Distribution Function) model such as the Cook-Torrance model described in [Cook1982] is fit to D by minimizing an error function $E(p_D)$ which is based on the analytical BRDF model used and the set of parameter values for the model:

$$E(p_D) = \sum_{s=1}^{N} \left\| \int_{\Omega} \rho(p_D, \omega_i, \omega_o) \cos\theta_i L_i(\omega_i) d\omega_i - D_s \right\| \qquad \text{(formula 5)}$$

where $\rho$ is the analytical BRDF model used and $p_D$ is the set of parameter values for the model. $\theta_i$ is the (elevation) angle between surface normal and $\omega_i$.

The error function $E(p_D)$ is minimized using any standard non-linear optimization algorithm like Levenberg-Marquardt. The result of the minimization is the set of model parameters $p_D$ among which $p_{D,spec}$ is the specularity parameter assumed to be linear in specularity. In the further calculations this specularity parameter is considered only.

If the simple reflectance scanner and hence the measurement values $D_s$ do not provide any hint about the specularity of the source material the sub procedure is terminated (box 52).

Otherwise, the specularity of the simulated target material is determined from the reflectance values in B' (box 53). For this the same analytical BRDF (Bidirectional Reflectance Distribution Function) model such as the Cook-Torrance model described in [Cook1982] is fit to B' by minimizing an error function $E(p_B)$ based on the analytical BRDF model used and the set of parameter values for the model:

$$E(p_B) = \sum_{x \in P} w_x \int_{\Omega} \left\| \rho(p_B, \omega_i, \omega_o) \cos\theta_i - B'(x, \omega_i, \omega_o) \right\| d\omega_i \qquad \text{(formula 6)}$$

where $\rho$ is the analytical BRDF model used and $p_B$ is the set of parameter values for the model. $\theta_i$ is the (elevation) angle between surface normal and $\omega_i$.

The error function $E(p_B)$ is minimized using any standard non-linear optimization algorithm like Levenberg-Marquardt. The result of the minimization is a (different) set of model parameters $p_B$ among which $p_{B,spec}$ is the specularity parameter assumed to be linear in specularity. In the further calculations this specularity parameter is considered only.

In the next step (box 54) a ratio $F_{spec}$ of the specularity parameters $p_{D,spec}$ and $p_{B,spec}$ is calculated:

$$F_{spec} = \frac{p_{D,spec}}{p_{B,spec}} \qquad \text{(formula 7)}$$

This ratio $F_{spec}$ determines which filter kernel (angular blurring or angular sharpening) of the Kautz specularity operator has to be used. $F_{spec} < 1$ means angular blurring and $F_{spec} > 1$ means angular sharpening.

In a final step (box 55) depending on $F_{spec}$ either the angular blurring or the angular sharpening operator from [Kautz2007] is run on (applied to) all selected pixels $x \in P$ of B'.

The embodiment of the inventive method set forth above is suitable for any material, i.e. for the most general case, where little can be assumed about the BTFs B and B'. For certain classes of materials, in particular the classes of near-homogeneous, near-flat and paint materials, particularly automotive paint materials, the editing steps become less complex by using more compact representations or models of the BTF which allow for easier optimization of error functions specifically designed for them.

In case of near-homogeneous, near-flat materials, a much more efficient representation of materials can be chosen, so that the parameters of B and B' contain already more semantic information. One example of this is the Spatially-Varying Bidirectional Reflectance Distribution Function (SVBRDF), especially in combination with a normal- or height-map to model the surface height variations. Reducing a measured BTF to such a representation is well known and not part of the present invention.

In a representation like the SVBRDF, the material is described by a BRDF model and a local coordinate frame per pixel. Since it is assumed that no spatial information is provided by the simple reflectance scanner, the surface structure cannot be changed and therefore the local coordinate frames have to be kept fixed.

To find new per-pixel parameter values for the BRDF model(s), again optimization of the error function E(B') is employed. The difference to the generic case discussed above is, that there are much fewer unknown parameters for the error function and that all parameters have a semantic, physical meaning. This makes the evaluation of the first part of the error function very efficient. Furthermore, the second part - the physical plausibility term - is now well defined, since simple bounds can be given on the model parameters to ensure physical plausibility of the model result.

Car paint materials typically are homogeneous up to the distortion by the sparkling due to certain pigments or flakes incorporated in the paints. Since car paints are near-homogeneous materials, the whole measured surface area of the reference material can be included into the editing process by setting P to the set of all pixels.

The characteristic properties of car paints allow for a special representation of a BTF in which representation the BTF is split into a homogeneous part and a sparkle part.

The BRDF describing the homogeneous part of the surface is represented using the Cook-Torrance BRDF model [Cook1982] and an angular-dependent color table. The residual contains the local effects caused by the flakes, e.g. sparkling, and is represented by a specially encoded BTF. This special representation of a BTF is based on a hybrid model explained in full detail in [Rump2008] and [Rump2009]. The BTF model can be summarized by:

$$B(x,\omega_i,\omega_o) = \rho_{gray}(p,\omega_i,\omega_o)\cos\theta_i \cdot C(\omega_i,\omega_o) + \rho_{flakes}(x,\omega_i,\omega_o) \quad \text{(frm. 8)}$$

Here, $\rho_{gray}$ is a gray scale, homogeneous Bidirectional Reflectance Distribution Function BRDF of the paint represented by an analytical BRDF model having parameters $p$, $C$ is a bi-directional color table and $\rho_{flakes}$ is a residual BTF containing the local effects of the flakes meaning that $\rho_{flakes}$ is zero mean on a global scale. $x$ denotes the pixels, $\omega_i$ and $\omega_o$ are the illumination and viewing directions and $\theta_i$ is the elevation angle corresponding to $\omega_i$, i.e. the angle between the surface normal and the direction $\omega_i$.

The BRDF model $\rho_{gray}$ is a modified Cook-Torrance model [Cook1982] and is defined as:

$$\rho_{gray}(p,\omega_i,\omega_o) = \frac{\cos\theta_i'}{\cos\theta_i}\left[\frac{p_{diff}}{\pi} + \sum_{k=1}^{K} p_{spec}^k \frac{G(\omega_i',\omega_o')F(p_F^k,\omega_i',\omega_o')BM(p_{rough}^k,\omega_i',\omega_o')}{4\pi\cos\theta_i'\cos\theta_o'}\right]$$

Where $\omega_i'$, $\omega_o'$ are the directions $\omega_i$, $\omega_o$ refracted by the clearcoat of the car paint having refractive index $p_{IOR}$. $\theta$ denotes the angle between normal and the respective $\omega$. $F$ is the Fresnel equation, G is a geometry term and *BM* the Beckmann microfacet distribution function, all three as defined in [Cook1982]. $p_{diff}$ and $p_{spec}^k$ are the diffuse and k-th lobe specular factor, $p_F^k$ is the micro facet reflection of lobe k at normal incidence and $p_{rough}^k$ is the roughness parameter for the Beckmann function for the lobe k.

C is defined by interpolating between M sample points $\tilde{C}_j$ with accompanying angles $\left(\omega_i^{C,j},\omega_o^{C,j}\right)$ on the bi-hemisphere. This is formalized by the interpolation operator $Y : C(\omega_i,\omega_o) := Y\left(\omega_i,\omega_o,\tilde{C},\omega_i^{C,j},\omega_o^{C,j}\right)$.

$\rho_{flakes}$ is a complete BTF again, which can be encoded efficiently as described in [Rump2009]. However, as it will become evident further down, the exact encoding of $\rho_{flakes}$ is not relevant to the present invention.

Since car paints are homogeneous materials up to local distortion by flake effects the whole measured surface area of the reference material is included into the editing process by setting $P$ to the set of all pixels. Selecting pixels therefore reduces to assigning all pixels the same weight or no weight at all.

The three distinct parts of the paint representation are edited in three steps:

- New parameters p' for the BRDF model $\rho_{gray}$ are calculated by matching the grayscale reflectances with the given sparse reflectance values D.

- The entries $\tilde{C}_j$ of color table C are recomputed to match the colors to the sparse measured reflectance values D.

- Colors in all pixels of the flake BTF $\rho_{flakes}$ are changed to match the edit performed on C and the angular distribution of the images in $\rho_{flakes}$ is changed according to the edit performed on $\rho_{gray}$. Since no spatial information is given in D, no sensible changes to the distribution of the flake effects within one image of the flake BTF $\rho_{flakes}$ are possible.

More specifically in the first step, new values for the diffuse and specular coefficients as well as the roughness parameters of the Cook-Torrance model are determined using optimization. For the second step, the original color table is first warped in angular domain based on the average surface roughness change. Since the bi-angular color change of metallic paints depends on the alignment of the flake particles, and since the roughness parameter reflects the degree of misalignment, this operation corrects for the difference in flake alignment between the source and target paint. Also in the second step, a color operator is applied to the entries of the original color table to match the colors from D. This color operator depends on the color or spectral space in which the color table is defined. A typical transformation has just a few parameters. An example would be a hue and saturation change operator. In the third step, a modified flake BTF is created by applying the same angular warping and color transformation from the second step to all pixels of the flake BTF.

When these three steps have been performed, the new car paint already matches the reflectance samples in D. No further iterations as in the general case explained further above are necessary.

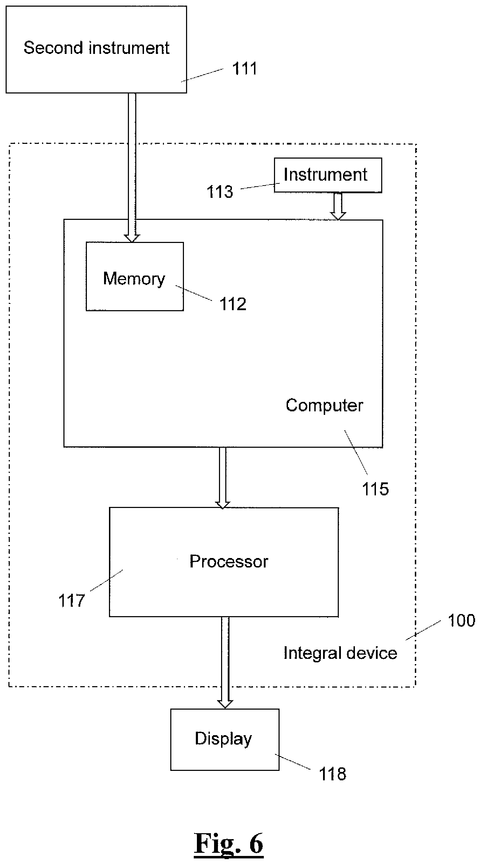

A typical embodiment of the inventive system for carrying out the inventive method is shortly outlined hereinafter with reference to Fig. 6.

The system comprises a memory 112 for storing a first set of data indicative of the values of measured appearance attributes of the reference material, with the measured appearance attributes being measured at a plurality of locations on the reference material and for a plurality of illumination directions or a plurality of viewing directions relative to each of the locations; an instrument 113 (referred to herein before as simple scanner) for measuring at least one appearance attribute of the source material and generating a second set of data indicative of a value of the measured appearance attribute, wherein the appearance attribute of the source material includes at least one, but not all, of the appearance attributes being measured on the reference material; and a computer 115 configured to receive the first and second sets of data and configured to determine a third set of data indicative of the synthesized appearance of the simulated material based at least in part on data from the second set of data associated with the physically tangible source material and at least in part on data from the first set of data of measured attributes of the physically tangible reference material different from that of the second set of data.

The system further comprises a processor 117 configured to receive data from the third set of data and configured to form an image representative of the synthesized appearance of the simulated material based at least in part on the data from the third set of data. The image is displayed on a display device 118.

The processor 117 can also be configured to produce an object having the synthesized appearance of the simulated material based at least in part on the data from the third set of data.

At least a portion of the memory 112 for storing the first set of data can be carried on the computer.

The computer 115 and the instrument 113 are combined in a single integral device 100. The processor 117 may also be part of the single integral device 100.

Transmitting means may be provided to transmit data from the first and second sets of data via media selected from the group consisting of a hardware connection, a wireless connection or a portable memory device.

The instrument 113 comprising at least one source of EM radiation in the range of near IR, UV or humanly detectable frequency spectra. Preferably the instrument source emits the full spectra of EM radiation in the range of near IR, UV and humanly detectable frequency spectra. Alternatively, the instrument source emits a selected spectrum of EM radiation from the range of near IR, UV and humanly detectable frequency spectra.

The instrument further comprises at least one detector for measuring EM radiation reflected from or transmitted through the source material when illuminated by the source of EM radiation, and determining values of the appearance attributes of the source material.

The system further comprises a second instrument 111 (referred to herein before as complex scanner) for measuring appearance attributes of the physically tangible reference material at a plurality of locations on the reference material by illuminating each of the locations on the reference material with EM radiation in the range of near IR, UV or humanly detectable frequency spectra from a plurality of illumination directions and measuring the EM radiation reflected from or transmitted through the reference material from a plurality of viewing directions, and determining values of the appearance attributes of the reference material based on the reflected or transmitted EM radiation for data of the first set of data.

The invention has been described in full detail on the basis of an embodiment wherein the first and third sets of data constitute a Bidirectional Texture Function BTF or a specific simplified representation thereof. It should be understood, however that this embodiment is given by way of illustration only. From the above discussion and the described embodiment, one skilled in the art can ascertain the essential characteristics of this invention, and without departing from the scope of the appended claims, can make various changes and modifications of the invention to adapt it to various usages and conditions. Thus, various modifications of the invention in addition to those shown and described herein will be apparent to those skilled in the art from the foregoing description.

References:

N. Alldrin, T. Zickler, D. Kriegman: "Photometric stereo with non-parametric and spatially-varying reflectance". In Computer Vision and Pattern Recognition. CVPR 2008. IEEE Conference on, pp. 1-8, 2008. ([Alldrin 2008])

X. An, F. Pellacini: "AppProp: All-Pairs Appearance-Space Edit Propagation". In ACM Transactions on Graphics, Vol. 27, No. 3, pp. 40:1-40:9, 2008. ([An 2008])

X. An, X. Tong, J. D. Denning, F. Pellacini: "AppWarp: retargeting measured materials by appearance-space warping" ACM Transactions on Graphics, Vol. 30, No. 6, pp. 147:1-147:10, 2011. ([An 2011])

R.L. Cook and K.E. Torrance: "A reflectance model for computer graphics" In ACM Transactions on Graphics, Vol. 1, Issue 1, pp. 7-24, 1982.([Cook 1982])

K. Daubert, H. Lensch, W. Heidrich, H.-P. Seidel: "Efficient cloth modeling and rendering" In Rendering Techniques 2001, pp. 63-70, 2011. ([Daubert 2001])

M. Guthe, G. Müller, M. Schneider, R. Klein: "BTF-CIELab: A Perceptual Difference Measure for Quality Assessment and Compression of BTFs" In Computer Graphics Forum, Vol. 28, No. 1, pp. 101-113, 2009. ([Guthe 2009])

J. T. Kajiya: "The Rendering Equation" In ACM SIGGRAPH Computer Graphics, Vol. 20, No. 4, pp. 143-150, 1986 ([Kajiya 1986])

J. Kautz, S. Boulos, F. Durand: "Interactive editing and modeling of bidirectional texture functions" In ACM Transactions on Graphics, Vol. 26, No. 3, Article No. 53, 2007 ([Kautz 2007])

J. Lawrence, A. Ben-Artzi, C. DeCoro, W. Matusik, H. Pfister, R. Ramamoorthi, S. Rusinkiewicz: "Inverse shade trees for non-parametric material representation and editing" In ACM Transactions on Graphics, Vol. 25, No. 3, pp. 735-745, 2006. ([Lawrence 2006])

D. McAllister, A. Lastra, W. Heidrich: "Efficient rendering of spatial bi-directional reflectance distribution functions" In Proceedings of the ACM SIGGRAPH/EUROGRAPHICS conference on Graphics hardware, pp. 79-88, 2002. ([McAllister 2002])

M. Rump, G. Müller, R. Sarlette, D. Koch, and R. Klein: "Photo-realistic Rendering of Metallic Car Paint from Image-Based Measurements" In Computer Graphics Forum, Vol. 27, No. 2, pp. 527-536, 2008. ([Rump 2008])

M. Rump, R. Sarlette, R. Klein: "Efficient Resampling, Compression and Rendering of Metallic and Pearlescent Paint," In proceedings of Vision, Modeling, and Visualization, pages 11-18, 2009 ([Rump 2009])

M. Rump, R. Klein: "Spectralization: Reconstructing spectra from sparse data" In Eurographics Symposium on rendering 2010, Vol. 29, No. 4, pp.1347-1354 ([Rump 2010])

R. Ruiters, R. Klein: "BTF based Material representation: Current Challenges" In Eurographics Workshop on Material Appearance Modeling 2013, pp.17-20 ([Ruiters 2013])

S. Rusinkiewicz: "A new change of variables for efficient BRDF representation" In Rendering techniques' 98, pp. 11-22, 1998 ([Rusinkiewicz 1998])

Kun Xu, Jiaping Wang, Xin Tong, Shi-Min Hu, Baining Guo: "Edit Propagation on Bidirectional Texture Functions" In Computer Graphics Forum,Vol. 28, No. 7, pp. 1871-1877 ,2009 ([Kun 2009])

**Claims**

1. Method of digitally generating data indicative of a synthesized appearance of a simulated material having physically plausible appearance attributes, with the synthesized appearance being based on a physically tangible reference material and at least one value of a selected appearance attribute of a physically tangible source material different from the reference material, comprising the steps of:

   a) accessing a first set of data indicative of the values of measured appearance attributes of the reference material, with the measured appearance attributes being measured at a plurality of locations on the reference material and for a plurality of illumination directions or a plurality of viewing directions relative to each of the locations;
   b) accessing a second set of data indicative of a value of at least one measured appearance attribute of the source material, wherein the appearance attribute of the source material includes at least one, but not all, of the appearance attributes being measured on the reference material; and
   c) determining a third set of data indicative of the synthesized appearance of the simulated material based at least in part on data from the second set of data associated with the physically tangible source material and at least in part on data from the first set of data of measured attributes of the physically tangible reference material different from that of the second set of data,

   **characterized in that**: step c) comprises:

   i) determining a third set of data indicative of the synthesized appearance of the simulated material based at least in part on the values of the measured appearances attributes of the source material and the values of the measured appearance attributes of the reference material,
   ii) determining an error value consisting of

   iia) the difference between a parameter of a measured appearance attribute of the source material and the same parameter of the corresponding appearance attribute in the third set of data,
   iib) a physical plausibility value based on the difference between a parameter of a measured appearance attribute of the reference material and the same parameter of the corresponding measured appearance attribute in the third set of data,

   iii) if the error value is greater than a predetermined threshold, then revising the determining of the third set of data indicative of the synthesized appearance of the simulated material, and
   iv) repeating steps i) through iii) until the error value is less than the predetermined threshold.

2. The method according to claim 1, further comprising measuring appearance attributes of the physically tangible reference material at a plurality of locations on the reference material by illuminating each of the locations on the reference material with EM radiation in the range of near IR, UV or humanly detectable frequency spectra from a plurality of illumination directions and measuring the EM radiation reflected from or transmitted through the reference material, preferably from a plurality of viewing directions, and determining values of the appearance attributes of the reference material based on the reflected or transmitted EM radiation to form the first set of data.

3. The method according to any one of the preceding claims, wherein the first set of data constitutes a Bidirectional Texture Function (BTF), a Bi-Directional Scattering-Surface Reflectance Distribution Function (BSSRDF), a Spatially Varying Bi-Directional Transmission Distribution Function (SVBTDF), or a Spatially Varying Bi-Directional Reflectance Distribution Function (SVBRDF).

4. The method according to any one of the preceding claims, wherein the second set of data is indicative of values of a plurality of measured appearance attributes of the source material, and wherein the appearance attributes of the source material include some, but not all, of the appearance attributes being measured on the reference material.

5. The method according to any one of the preceding claims, wherein the appearance attributes are selected from the group consisting of lightness, saturation, hue, gloss, specularity, distinctness of image, haze, subsurface scattering, translucency, turbidity, texture, surface height variation and normal maps.

6. The method according to any one of the preceding claims, further comprising processing the third set of data to form an image representative of the synthesized appearance of the simulated material.

7. System for digitally generating data indicative of a synthesized appearance of a simulated material having physically plausible appearance attributes, with the synthesized appearance being based on a physically tangible reference material and at least one value of a selected appearance attribute of a physically tangible source material different from the reference material, the system comprising:

a) a memory (112) for storing a first set of data indicative of the values of measured appearance attributes of the reference material, with the measured appearance attributes being measured at a plurality of locations on the reference material and for a plurality of illumination directions or a plurality of viewing directions relative to each of the locations;

b) an instrument (113) for measuring at least one appearance attribute of the source material and generating a second set of data indicative of a value of the measured appearance attribute, wherein the appearance attribute of the source material includes at least one, but not all, of the appearance attributes being measured on the reference material; and

c) a computer (115) configured to receive the first and second sets of data and configured to determine a third set of data indicative of the synthesized appearance of the simulated material based at least in part on data from the second set of data associated with the physically tangible source material and at least in part on data from the first set of data of measured attributes of the physically tangible reference material different from that of the second set of data,

**characterized in that**: the computer (115) is further configured to:

determine a third set of data indicative of the synthesized appearance of the simulated material based at least in part on the values of the measured appearances attributes of the source material and the values of the measured appearance attributes of the reference material,

determine an error value consisting of

a) the difference between a parameter of a measured appearance attribute of the source material and the same parameter of the corresponding appearance attribute in the third set of data,

b) a physical plausibility value based on the difference between a parameter of a measured appearance attribute of the reference material and the same parameter of the corresponding measured appearance attribute in the third set of data,

wherein if the error value is greater than a predetermined threshold, then the determining of the third set of data indicative of the synthesized appearance of the simulated material is revised, and

repeat the determining until the error value is less than the predetermined threshold.

**Patentansprüche**

1. Verfahren zum digitalen Erzeugen von Daten, die ein synthetisiertes Erscheinungsbild eines simulierten Materials mit physisch plausiblen Erscheinungsbildattributen angeben, wobei das synthetisierte Erscheinungsbild auf einem physisch greifbaren Referenzmaterial basiert und mindestens ein Wert eines ausgewählten Erscheinungsbildattributs eines physisch greifbaren Quellenmaterials sich von dem Referenzmaterial unterscheidet, das die Schritte umfasst:

a) Zugreifen auf einen ersten Datensatz, der Werte von gemessenen Erscheinungsbildattributen des Referenzmaterials angibt, wobei die gemessenen Erscheinungsbildattribute an mehreren Orten an dem Referenzmaterial und für mehrere Beleuchtungsrichtungen oder mehrere Blickrichtungen relativ zu jedem von den Orten gemessen werden;

b) Zugreifen auf einen zweiten Datensatz, der Werte von mindestens einem gemessenen Erscheinungsbildattribut des Quellenmaterials angibt, wobei das Erscheinungsbildattribut des Quellenmaterials mindestens eines, aber nicht alle, von den Erscheinungsbildattributen umfasst, die an dem Referenzmaterial gemessen werden; und

c) Bestimmen eines dritten Datensatzes, der das synthetisierte Erscheinungsbild des simulierten Materials angibt, basierend mindestens teilweise auf Daten von dem zweiten Datensatz, der mit dem physisch greifbaren Quellenmaterial verbunden ist, und mindestens teilweise auf Daten von dem ersten Datensatz von gemessenen Attributen des physisch greifbaren Referenzmaterials, die sich von denen des zweiten Datensatzes unterscheiden,

**dadurch gekennzeichnet, dass**:

Schritt c) umfasst:

i) Bestimmen eines dritten Datensatzes, der das synthetisierte Erscheinungsbild des simulierten Materials angibt, basierend mindestens teilweise auf den Werten der gemessenen Erscheinungsbildattribute des Quellenmaterials und den Werten der gemessenen Erscheinungsbildattribute des Referenzmaterials,

ii) Bestimmen eines Fehlerwertes bestehend aus

iia) dem Unterschied zwischen einem Parameter eines gemessenen Erscheinungsbildattributes des Quellenmaterials und dem gleichen Parameter des entsprechenden Erscheinungsbildattributes in dem dritten Datensatz,

iib) einem physischen Plausibilitätswert basierend auf dem Unterschied zwischen einem Parameter eines gemessenen Erscheinungsbildattributes des Referenzmaterials und dem gleichen Parameter des entsprechenden gemessenen Erscheinungsbildattributes in dem dritten Datensatz,

iii) wenn der Fehlerwert größer als ein vorgegebener Schwellenwert ist, dann Revidieren der Bestimmung des dritten Datensatzes, der das synthetisierte Erscheinungsbild des simulierten Materials angibt, und

iv) Wiederholen der Schritte i) bis iii), bis der Fehlerwert kleiner als der vorbestimmte Schwellenwert ist.

2. Verfahren nach Anspruch 1, ferner umfassend das Messen von Erscheinungsbildattributen des physisch greifbaren Referenzmaterials an mehreren Orten an dem Referenzmaterial durch Beleuchten von jedem der Orte an dem Referenzmaterial mit EM-Strahlung im Bereich von Nah-IR-, UV- oder menschlich nachweisbaren Frequenzspektren von mehreren Beleuchtungsrichtungen und Messen der EM-Strahlung, die durch das Referenzmaterial reflektiert wird oder durch es hindurch gesendet wird, bevorzugt von mehreren Blickrichtungen, und Bestimmen von Werten der Erscheinungsbildattribute des Referenzmaterials basierend auf der reflektierten oder gesendeten EM-Strahlung, um den ersten Datensatz zu bilden.

3. Verfahren nach einem der vorstehenden Ansprüche, wobei der erste Datensatz eine Bidirectional Texture Function (bidirektionale Texturierungsfunktion; BTF), eine Bi-Directional Scattering-Surface Reflectance Distribution Function (bidirektionale Streuoberflächen-Reflektanzverteilungsfunktion BSSRDF), eine Spatially Varying Bi-Directional Transmission Distribution Function (räumlich variierende bidirektionale Übertragungsverteilungsfunktion; SVBTDF) oder eine Spatially Varying Bi-Directional Reflectance Distribution Function (räumlich variierende bidirektionale Reflektanzverteilungsfunktion; SVBRDF) bildet.

4. Verfahren nach einem der vorstehenden Ansprüche, wobei der zweite Datensatz Werte von mehreren gemessenen Erscheinungsbildattributen des Quellenmaterials angibt, und wobei die Erscheinungsbildattribute des Quellenmaterials einige, aber nicht alle, von den Erscheinungsbildattributen umfassen, die an dem Referenzmaterial gemessen werden.

5. Verfahren nach einem der vorstehenden Ansprüche, wobei die Erscheinungsbildattribute ausgewählt sind aus der Gruppe bestehend aus Helligkeit, Sättigung, Farbton, Glanz, Spiegelung, Bilddeutlichkeit, Trübung, Volumenstreuung, Transparenz, Trübheit, Textur, Oberflächenhöhenvariation und Normal Maps.

6. Verfahren nach einem der vorstehenden Ansprüche, ferner umfassend das Verarbeiten des dritten Datensatzes, um ein Bild zu bilden, welches das synthetisierte Erscheinungsbild des simulierten Materials darstellt.

7. System zum digitalen Erzeugen von Daten, die ein synthetisiertes Aussehen eines simulierten Materials mit physisch plausiblen Erscheinungsbildattributen, wobei das synthetisierte Erscheinungsbild auf einem physisch greifbaren Referenzmaterial basiert und mindestens ein Wert eines ausgewählten Erscheinungsbildattributs eines physisch greifbaren Quellenmaterials sich von dem Referenzmaterial unterscheidet, wobei das System umfasst:

a) einen Speicher (112) zum Speichern eines ersten Datensatzes, der Werte von gemessenen Erscheinungsbildattributen des Referenzmaterials angibt, wobei die gemessenen Erscheinungsbildattribute an mehreren Orten an dem Referenzmaterial und für mehrere Beleuchtungsrichtungen oder mehrere Blickrichtungen relativ zu jedem von den Orten gemessen sind;

b) ein Instrument (113) zum Messen von mindestens einem Erscheinungsbildattribut des Quellenmaterials und das Erzeugen eines zweiten Datensatzes, der einen Wert des gemessenen Erscheinungsbildattributs angibt, wobei das Erscheinungsbildattribut des Quellenmaterials mindestens eines, aber nicht alle, von den Erscheinungsbildattributen umfasst, die an dem Referenzmaterial gemessen werden; und

c) einen Computer (115), der konfiguriert ist, die ersten und zweiten Datensätze zu empfangen, und konfiguriert ist, einen dritten Datensatz, der das synthetisierte Erscheinungsbild des simulierten Materials angibt, basierend mindestens teilweise auf Daten von dem zweiten Datensatz, der mit dem physisch greifbaren Quellenmaterial verbunden ist, und mindestens teilweise auf Daten von dem ersten Datensatz von gemessenen Attributen des physisch greifbaren Referenzmaterials, die sich von denen des zweiten Datensatzes unterscheiden, zu bestimmen,

**dadurch gekennzeichnet, dass**:

der Computer (115) ferner konfiguriert ist zum:

Bestimmen eines dritten Datensatzes, der das synthetisierte Erscheinungsbild des simulierten Materials angibt, basierend mindestens teilweise auf den Werten der gemessenen Erscheinungsbildattribute des Quellenmaterials und den Werten der gemessenen Erscheinungsbildattribute des Referenzmaterials,

Bestimmen eines Fehlerwertes bestehend aus

a) dem Unterschied zwischen einem Parameter eines gemessenen Erscheinungsbildattributes des Quellenmaterials und dem gleichen Parameter des entsprechenden Erscheinungsbildattributes in dem dritten Datensatz,

b) einem physischen Plausibilitätswert basierend auf dem Unterschied zwischen einem Parameter eines gemessenen Erscheinungsbildattributes des Referenzmaterials und dem gleichen Parameter des entsprechenden gemessenen Erscheinungsbildattributes in dem dritten Datensatz,

wobei, wenn der Fehlerwert größer als ein vorgegebener Schwellenwert ist, die Bestimmung des dritten Datensatzes, der das synthetisierte Erscheinungsbild des simulierten Materials angibt, revidiert wird, und wiederholen des Bestimmens, bis der Fehlerwert kleiner als der vorbestimmte Schwellenwert ist.

## Revendications

**1.** Procédé de génération numérique de données indiquant un aspect synthétisé d'un matériau simulé ayant des attributs d'aspect physiquement plausibles, l'aspect synthétisé étant basé sur un matériau de référence physiquement tangible et au moins une valeur d'un attribut d'aspect sélectionné d'un matériau source physiquement tangible différent du matériau de référence, comprenant les étapes consistant à :

a) l'accès à un premier ensemble de données indiquant les valeurs d'attributs d'aspect mesurés du matériau de référence, les attributs d'aspect mesurés étant mesurés à une pluralité d'emplacements sur le matériau de référence et pour une pluralité de directions d'illumination ou une pluralité de directions de visualisation par rapport à chacun des emplacements ;

b) l'accès à un deuxième ensemble de données indiquant une valeur d'au moins un attribut d'aspect mesuré du matériau source, l'attribut d'aspect du matériau source comprenant au moins l'un, mais pas la totalité, des attributs d'aspect en cours de mesure sur le matériau de référence ; et

c) la détermination d'un troisième ensemble de données indiquant l'aspect synthétisé du matériau simulé sur la base, au moins en partie, de données provenant du deuxième ensemble de données associées au matériau source physiquement tangible et au moins en partie de données provenant du premier ensemble de données d'attributs mesurés du matériau de référence physiquement tangible différents de ceux du deuxième ensemble de données,

**caractérisé en ce que** :

l'étape c) comprend :

i) la détermination d'un troisième ensemble de données indiquant l'aspect synthétisé du matériau simulé sur la base, au moins en partie, des valeurs des attributs d'aspects mesurés du matériau source et des valeurs des attributs d'aspects mesurés du matériau de référence,

ii) la détermination d'une valeur d'erreur constituée par

iia) la différence entre un paramètre d'un attribut d'aspect mesuré du matériau source et le même paramètre de l'attribut d'aspect correspondant dans le troisième ensemble de données,

iib) une valeur de plausibilité physique basée sur la différence entre un paramètre d'un attribut d'aspect mesuré du matériau de référence et le même paramètre de l'attribut d'aspect mesuré correspondant dans le troisième ensemble de données,

iii) si la valeur d'erreur est supérieure à un seuil prédéterminé, la révision de la détermination du troisième ensemble de données indiquant l'aspect synthétisé du matériau simulé, et
iv) la répétition des étapes i) à iii) jusqu'à ce que la valeur d'erreur soit inférieure au seuil prédéterminé.

**2.** Procédé selon la revendication 1, comprenant en outre la mesure d'attributs d'aspect du matériau de référence physiquement tangible à une pluralité d'emplacements sur le matériau de référence par l'illumination de chacun des emplacements sur le matériau de référence avec un rayonnement EM dans la plage du proche IR, UV, ou des spectres de fréquence humainement détectables depuis une pluralité de directions d'illumination et la mesure du rayonnement EM réfléchi par ou transmis à travers le matériau de référence, de préférence depuis une pluralité de directions de visualisation, et la détermination de valeurs des attributs d'aspect du matériau de référence sur la base du rayonnement EM réfléchi ou transmis pour former le premier ensemble de données.

**3.** Procédé selon l'une quelconque des revendications précédentes, dans lequel le premier ensemble de données constitue une fonction de texture bidirectionnelle (BTF), une fonction de distribution de facteur de réflexion de la diffusion de surface bidirectionnelle (BSSRDF), une fonction de distribution de transmission bidirectionnelle variable dans l'espace (SVBTDF) ou une fonction de distribution de facteur de réflexion bidirectionnelle variable dans l'espace (SVBRDF).

**4.** Procédé selon l'une quelconque des revendications précédentes, dans lequel le deuxième ensemble de données indique des valeurs d'une pluralité d'attributs d'aspect mesurés du matériau source, et dans lequel les attributs d'aspect du matériau source comprennent certains, mais pas la totalité, des attributs d'aspect en cours de mesure sur le matériau de référence.

**5.** Procédé selon l'une quelconque des revendications précédentes, dans lequel les attributs d'aspect sont sélectionnés dans le groupe constitué par la clarté, la saturation, la tonalité, la brillance, la spécularité, la netteté d'image, la diffusion globale, la transluminescence, la translucidité, la turbidité, la texture, la variation de la hauteur de surface et les cartes de normales (en anglais « normal maps »).

**6.** Procédé selon l'une quelconque des revendications précédentes, dans lequel, comprenant en outre le traitement du troisième ensemble de données pour former une image représentative de l'aspect synthétisé du matériau simulé.

**7.** Système de génération numérique de données indiquant un aspect synthétisé d'un matériau simulé ayant des attributs d'aspect physiquement plausibles, l'aspect synthétisé étant basé sur un matériau de référence physiquement tangible et au moins une valeur d'un attribut d'aspect sélectionné d'un matériau source physiquement tangible différent du matériau de référence, le système comprenant :

a) une mémoire (112) destinée à stocker un premier ensemble de données indiquant les valeurs d'attributs d'aspect mesurés du matériau de référence, les attributs d'aspect mesurés étant mesurés à une pluralité d'emplacements sur le matériau de référence et pour une pluralité de directions d'illumination ou une pluralité de directions de visualisation par rapport à chacun des emplacements ;
b) un instrument (113) destiné à mesurer au moins un attribut d'aspect de matériau source et à générer un deuxième ensemble de données indiquant une valeur de l'attribut d'aspect mesuré, l'attribut d'aspect du matériau source comprenant au moins l'un, mais pas la totalité, des attributs d'aspect en cours de mesure sur le matériau de référence ; et
c) un ordinateur (115) configuré pour recevoir les premier et deuxième ensembles de données et configuré pour déterminer un troisième ensemble de données sur la base, au moins en partie, de données provenant du deuxième ensemble de données associé au matériau source physiquement tangible et au moins en partie de données provenant du premier ensemble de données d'attributs mesurés du matériau de référence physiquement tangible différents de ceux du deuxième ensemble de données,

**caractérisé en ce que** :
l'ordinateur (115) est en outre configuré pour :

déterminer un troisième ensemble de données indiquant l'aspect synthétisé du matériau simulé sur la base, au moins en partie, des valeurs des attributs d'aspects mesurés du matériau source et des valeurs des attributs d'aspect mesurés du matériau de référence,
déterminer une valeur d'erreur constituée par

a) la différence entre un paramètre d'un attribut d'aspect mesuré du matériau source et le même paramètre de l'attribut d'aspect correspondant dans le troisième ensemble de données,
b) une valeur de plausibilité physique basée sur la différence entre un paramètre d'un attribut d'aspect mesuré du matériau de référence et le même paramètre de l'attribut d'aspect mesuré correspondant dans le troisième ensemble de données,

dans lequel si la valeur d'erreur est supérieure à un seuil prédéterminé, la détermination du troisième ensemble de données indiquant l'aspect synthétisé du matériau simulé est révisée, et
répéter la détermination jusqu'à ce que la valeur d'erreur soit inférieure au seuil prédéterminé.

$M_R$

$M_S$

| Complex reflectance scanner | Simple reflectance scanner (or database) |

11     13

| (B) First set of data

Densely captured reflectance values of reference material $M_R$ | (D) Second set of data

Sparsely captured reflectance values of source material $M_S$ |

12     14

Editing

15

(B') Third set of data

Edited densely populated BTF

16

Rendering

17

Displaying

18

**Fig. 1**

**Fig. 2**

start

Set initial values B' = B $\qquad$ 31

32 $\qquad$ Calculate error function E(B')

33

yes — end ← E(B') < threshold?

no

34 $\qquad$ Calculate parameters of editing operators

35 $\qquad$ Apply editing operators to B' to generate new BTF B''

36 $\qquad$ Mix B'' and B to form BTF B''':

$$B'''_x = w_x B''_x + (1-w_x)B_x$$

37 $\qquad$ Reinitialize B' = B'''

## Fig. 3

**Fig. 4**

**Fig. 5**

**Fig. 6**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20110148898 A

### Non-patent literature cited in the description

- **N. ALLDRIN ; T. ZICKLER ; D. KRIEGMAN.** Photometric stereo with non-parametric and spatially-varying reflectance. *Computer Vision and Pattern Recognition. CVPR 2008. IEEE Conference,* 2008, 1-8
- **X. AN, F. PELLACINI.** AppProp: All-Pairs Appearance-Space Edit Propagation. *ACM Transactions on Graphics,* 2008, vol. 27 (3), 40-1, 40-9
- **X. AN ; X. TONG ; J. D. DENNING ; F. PELLACINI.** AppWarp: retargeting measured materials by appearance-space warping. *ACM Transactions on Graphics,* 2011, vol. 30 (6), 147, , 1-147, 10
- **R.L. COOK ; K.E. TORRANCE.** A reflectance model for computer graphics. *ACM Transactions on Graphics,* 1982, vol. 1 (1), 7-24
- **K. DAUBERT ; H. LENSCH ; W. HEIDRICH ; H.-P. SEIDEL.** Efficient cloth modeling and rendering. *Rendering Techniques 2001,* 2011, 63-70
- **M. GUTHE ; G. MÜLLER ; M. SCHNEIDER ; R. KLEIN.** BTF-CIELab: A Perceptual Difference Measure for Quality Assessment and Compression of BTFs. *Computer Graphics Forum,* 2009, vol. 28 (1), 101-113
- **J. T. KAJIYA.** The Rendering Equation. *ACM SIGGRAPH Computer Graphics,* 1986, vol. 20 (4), 143-150
- **J. KAUTZ ; S. BOULOS ; F. DURAND.** Interactive editing and modeling of bidirectional texture functions. *ACM Transactions on Graphics,* 2007, vol. 26 (3
- **J. LAWRENCE ; A. BEN-ARTZI ; C. DECORO ; W. MATUSIK ; H. PFISTER ; R. RAMAMOORTHI ; S. RUSINKIEWICZ.** Inverse shade trees for non-parametric material representation and editing. *ACM Transactions on Graphics,* 2006, vol. 25 (3), 735-745
- **D. MCALLISTER ; A. LASTRA ; W. HEIDRICH.** Efficient rendering of spatial bi-directional reflectance distribution functions. *Proceedings of the ACM SIGGRAPH/EUROGRAPHICS conference on Graphics hardware,* 2002, 79-88
- **M. RUMP ; G. MÜLLER ; R. SARLETTE ; D. KOCH ; R. KLEIN.** Photo-realistic Rendering of Metallic Car Paint from Image-Based Measurements. *Computer Graphics Forum,* 2008, vol. 27 (2), 527-536
- **M. RUMP ; R. SARLETTE ; R. KLEIN.** Efficient Resampling, Compression and Rendering of Metallic and Pearlescent Paint. *proceedings of Vision, Modeling, and Visualization,* 2009, 11-18
- **M. RUMP ; R. KLEIN.** Spectralization: Reconstructing spectra from sparse data. *Eurographics Symposium on rendering 2010,* vol. 29 (4), 1347-1354
- **R. RUITERS ; R. KLEIN.** BTF based Material representation: Current Challenges. *Eurographics Workshop on Material Appearance Modeling 2013,* 17-20
- **S. RUSINKIEWICZ.** A new change of variables for efficient BRDF representation. *Rendering techniques,* 1998, vol. 98, 11-22
- **KUN XU ; JIAPING WANG ; XIN TONG ; SHI-MIN HU ; BAINING GUO.** Edit Propagation on Bidirectional Texture Functions. *Computer Graphics Forum,* 2009, vol. 28 (7), 1871-1877